# EUROPÄISCHE PATENTANMELDUNG

(11) **EP 0 547 618 A1**
(43) Veröffentlichungstag der Anmeldung: **23.06.1993**
(21) Anmeldenummer: 92121526.5
(22) Anmeldetag: 17.12.1992
(51) Int. Cl.: H05K 7/14

(54) **Haltevorrichtung für ein elektronisches Gerät mit einem Halteelement**

(30) Priorität: 19.12.1991 AT 2516/91
(71) Anmelder: Siemens Aktiengesellschaft Österreich, A-1210 Wien (AT)
(72) Erfinder: Werk, Leopold, A-1232 Wien (AT)
(74) Vertreter: Fuchs, Franz-Josef, Dr.-Ing.

(57) **Zusammenfassung**

Bei einer Haltevorrichtung für ein elektronisches Gerät (50) ist ein Halteelement (10) vorgesehen, welches geeignet ist anhand von Gleitelementen (21,22) zum Einschub in einen Baugruppenträger ebenso, wie auch anhand von Befestigungselementen (45,46) zur Wandmontage. Dadurch ist eine Vereinfachung in Form eines Kombinationsgerätes erzielbar.

## Beschreibung

Die Erfindung betrifft eine Haltevorrichtung für ein elektronisches Gerät mit einem Halteelement.

Eine derartige Haltevorrichtung ist erforderlich bei sehr unterschiedlichen Anwendungen. Demzufolge soll diese auch grundlegend unterschiedlich gestaltet sein. Bei bestimmten Anwendungen kann es erforderlich sein, daß diese elektronischen Geräte in einem Baugruppenträger insbesondere Platzsparend untergebracht werden sollen. Die elektronischen Geräte sollen dabei so konstruiert und gestaltet werden, daß sie eine Haltevorrichtung aufweisen mit einem Halteelement, an welchem ein Flächenstück vorgesehen ist mit Gleitelementen, so daß derartige elektronische Geräte zum Einschub in einen Baugruppenträger verwendbar sind. Ein derartiges Halteelement soll dabei speziell für diese Einschubtechnik konzipiert sein, so daß mehrere dieser elektronischen Geräte besonders platzsparend nebeneinander angeordnet werden können, sowie rasch und leicht dem Baugruppenträger entnommen und beispielsweise ausgetauscht oder kontrolliert werden können. In diesem Fall sollen die elektronischen Geräte von einer kompakten Form sein und speziell auf die Erfordernisse des Baugruppenträgers abgestimmt sein, beispielsweise betreffend die Kühlmöglichkeiten mittels eines Luftstromes, oder beispielsweise betreffend die Anschlußmöglichkeiten für Steckverbindungen.

Bei anderen Anwendungen von elektronischen Geräten kann es erforderlich sein, daß die elektronischen Geräte an einer Wand befestigt werden sollen. In diesem Fall sollen die elektronischen Geräte so konstruiert und gestaltet werden, daß sie eine Haltevorrichtung aufweisen mit einem Halteelement, an welchem ein Flächenstück vorgesehen ist mit Befestigungselementen zur Wandmontage des Halteelementes. Ein derartiges Halteelement soll dabei speziell für die Wandmontage konzipiert sein, sodaß das elektronische Gerät einzeln und insbesondere stabil an der Wand befestigt werden kann. In diesem Fall soll das elektronische Gerät speziell auf die Erfordernisse bei einer Wandmontage abgestimmt sein, und insbesondere stabil mit der Haltevorrichtung verbunden sein. Als Befestigungselemente für die Wandmontage können beispielsweise Lochbohrungen im Flächenstück vorgesehen sein, sodaß insbesondere mittels Schrauben durch die Lochbohrungen die Befestigung erfolgt.

Bedingt durch die unterschiedlichen Erfordernisse je nach Art der Anwendung des elektronischen Gerätes sowie je nach der Gestaltung der Haltevorrichtung und insbesondere des Halteelementes werden bei einem bestimmten elektronischen Gerät, welches entweder zum Einschub oder zur Wandmontage bei der Anwendung verfügbar sein soll, auch zwei unterschiedliche Ausführungsformen des elektronischen Gerätes konzipiert und gefertigt.

Während für die Wandmontage eine besonders stabile Variante des elektronischen Gerätes konzipiert ist, so ist für den Einschub eine besonders kompakte Ausführungsform des elektronischen Gerätes vorgesehen.

Es ist Aufgabe der Erfindung eine weitere Haltevorrichtung für ein elektronisches Gerät mit einem Halteelement anzugeben von zumindest einer bestimmten Ausführungsform, welche speziell zum Einschub in einen Baugruppenträger konzipierbar ist einerseits oder andererseits eine weitere Haltevorrich tung für ein elektronisches Gerät mit einem Halteelement anzugeben von zumindest einer bestimmten Ausführungsform, welche speziell konzipierbar ist zur Wandmontage.

Diese Aufgabe ist gelöst bei einer Haltevorrichtung für ein elektronisches Gerät mit einem Halteelement, welches dadurch gekennzeichnet ist, daß in Kombination
a) ein erstes Flächenstück des Halteelementes vorgesehen ist, welches Gleitelemente aufweist zum Einschub in einen Baugruppenträger
b) ein zweites Flächenstück des Halteelementes vorgesehen ist, welches Befestigungselemente aufweist zur Wandmontage des Halteelementes,
c) ein zumindest näherungsweise rechter Winkel zwischen dem ersten und dem zweiten Flächenstück vorgesehen ist.

Der Erfindung liegt die Idee zugrunde, daß das Halteelement ein erstes und ein zweites Flächenstück aufweist, sodaß ein zumindest näherungsweise rechter Winkel zwischen dem ersten und dem zweiten Flächenstück vorgesehen ist, sodaß dadurch das erste Flächenstück mittels Gleitelementen speziell zum Einschub in einen Baugruppenträger konzipiert werden kann, während das zweite Flächenstück gleichzeitig dazu mittels Befestigungselementen speziell zur Wandmontage konzipierbar ist. Insbesondere durch die Abwinkelung des Halteelementes ergibt sich der Vorteil, das Gerät in mehreren Lagen an einer Wand, oder in einem Schrank montieren zu können.

In einer vorteilhaften Weise ist eine Vereinfachung des Produktangebotes bei elektronischen Geräten erzielbar, sodaß sich bei der Fertigung Vorteile ergeben, indem die Vielfalt von zu fertigenden elektronischen Geräten reduzierbar ist.

Es werden zwei Gerätetypen durch eine Type ersetzt. Bei der Konstruktion des Kombinationsgerätes ist es erforderlich, sowohl auf die Lage der Anschlußelemente zu achten, insbesondere auf deren Zugänglichkeit bei Verwendung als Einschubgerät, als auch bei Verwendung als Wandgerät für verschiedene Einbaulagen die unterschiedlichen Verhältnisse bei der Wärmeabfuhr zu berücksichtigen. Bei einem derartigen Kombinationsgerät ist vorteilhaft, daß beim Kauf nicht entschieden werden muß, ob Wand- oder Einschubmontage vorgesehen sein soll. Weitere Vorteile ergeben sich aus der Verringerung der Typenvielfalt. Dies betrifft insbesondere die Fertigung, die Lagerhaltung und die Bestellorganisation. Es ergeben sich außerdem Preisvorteile durch höhere Stückzahlen, da die Stückzahl der Kombinationsgerate die Summe der Stückzahlen der Einschubgeräte und der Geräte für Wandmontage ist.

Ausführbar ist eine bevorzugte Haltevorrichtung, bei welcher das erste Flächenstück Befestigungselemente aufweist zur Wandmontage.

In einer vorteilhaften Weise sind insbesondere zwei Flächenstücke verfügbar für eine Befestigungsmöglichkeit an einer Wand. Insbesondere können die Befestigungselemente so konstruiert sein, daß eine waagrechte oder senkrechte oder in einem beliebigen Winkel benötigte Befestigung an einer Wand ermöglicht ist. Diese Wand kann senkrecht oder auch in einem beliebigen Winkel geneigt sein, also auch eine Bodenfläche oder Deckenfläche sein.

Ausführbar ist eine weitere bevorzugte Haltevorrichtung, bei welcher das Halteelement ein Druckgußteil ist mit integrierten Kühlkörpern.

In einer vorteilhaften Weise sind für elektronische Geräte, welche beispielsweise einen Leistungsteil aufweisen mit einer erforderlichen Kühlung, derartige Haltevorrichtungen einsetzbar.

Anhand von Figuren sollen bevorzugte Ausführungsbeispiele näher erläutert werden. In Zusammenhang mit den Figuren und der Beschreibung wird folgende Bezugszeichentabelle verwendet:

### Bezugszeichentabelle

- 10: Halteelement
- 20: erstes Flächenstück des Halteelementes
- 21,22: Gleitelement des ersten Flächenstückes
- 25,26: Befestigungselemente des ersten Flächenstückes
- 40: zweites Flächenstück des Halteelementes
- 45,46: Befestigungselement des zweiten Flächenstückes
- 50: elektronisches Gerät
- 51,52: Platinen des elektronischen Gerätes, bestückt mit elektronischen Bauteilen
- 53: Bandkabelverbindung
- 54: Federleisten für Steckklemmen
- 59: Befestigungsstege des elektronischen Gerätes zum Fixieren der Platinen
- 60: Kühlkörper
- 90: rechter Winkel zwischen dem ersten und dem zweiten Flächenstück

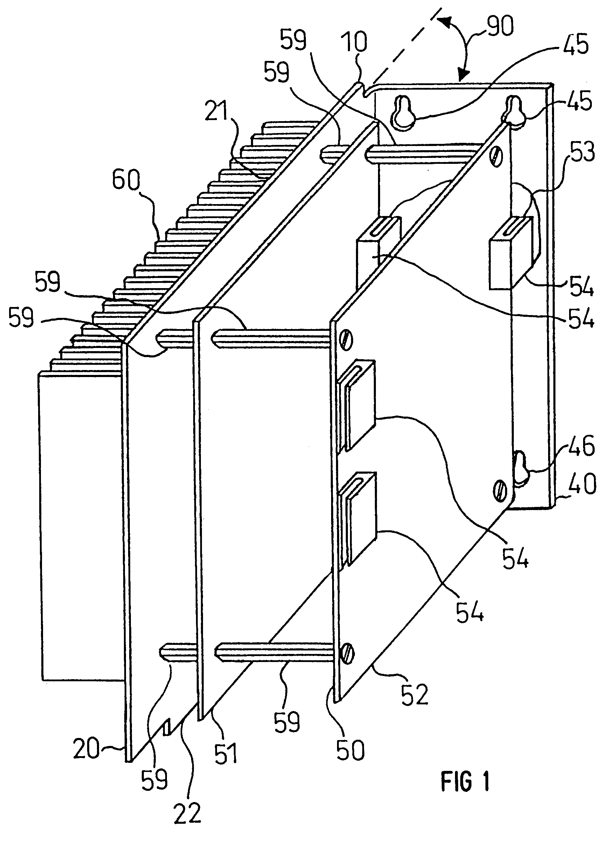

Wie die Fig. 1 zeigt, ist bei einem Ausführungsbeispiel für eine Haltevorrichtung ein Halteelement 10 vorgesehen. Diese Haltevorrichtung ist für ein elektronisches Gerät 50 vorgesehen, beispielsweise ein Stromrichtergerät oder ein Gerät der Leistungselektronik. Das elektronische Gerät 50 weist eine erste Platine 51 und eine zweite Platine 52 auf. Es sind Befestigungsstege 59 des elektronischen Gerätes 50 vorgesehen zum Fixieren der Platinen 51, 52 sowohl untereinander als auch am Halteelement 10. Für einen Austausch von elektrischen Signalen zwischen den Platinen 51, 52 ist eine Bandkabelverbindung 53 vorgesehen mit Hilfe von Federleisten 54 für die Steckklemmen der Bandkabelverbindung 53. Für eine Eingabe sowie Ausgabe von elektrischen Signalen sind weitere Federleisten 54 für Steckklemmen an der Platine 52 vorgesehen. Damit kann das elektronische Gerät 50 mit anderen elektronischen Geräten über Bandkabelverbindungen zum Austausch von elektrischen Signalen verbunden werden. Die Platinen 51, 52 des elektronischen Gerätes 50 sind bestückt mit in der Figur nicht dargestellten elektronischen Bauteilen. Desgleichen sind elektronische Bauteile, insbesondere Leistungshalbleiterbauelemente, am Halteelement 10 angeordnet. Zur Kühlung dieser elektronischen Bauteile sind am Halteelement 10 Kühlkörper 60 angeordnet.

Das Halteelement 10 weist ein erstes Flächenstück 20 und ein zweites Flächenstück 40 auf. Zwischen dem ersten Flächenstück 20 des Halteelementes 10 und dem zweiten Flächenstück 40 des Halteelementes 10 ist ein rechter Winkel 90 vorgesehen. Das erste Flächenstück 20 des Halteelementes 10 ist so geformt, daß ein Gleitelement 21 und ein Gleitelement 22 zueinander gegenüberliegend angeordnet sind. Die Gleitelemente 21, 22 des ersten Flächenstückes 20 sind verwendbar zum Einschub in einen Baugruppenträger. Hierfür sind die Gleitelemente 21, 22 schienenartig geformt, sodaß entlang dieser als gegenüberliegende Schienen dienenden Gleitelementen 21, 22 das Halteelement 10, und damit also die Haltevorrichtung mit dem elektronischen Gerät 50, in einen Baugruppenträger eingeschoben werden kann. Das zweite Flächenstück 40 weist mehrere Befestigungselemente 45, 46 auf. Die Befestigungselemente 45, 46 des zweiten Flächenstückes sind verwendbar zur Wandmontage des Halteelementes 10. Als Befestigungselemente 45, 46 des zweiten Flächenstückes 40 können beispielsweise Lochbohrungen vorgesehen sein, sodaß beispielsweise mit Hilfe von Schraubenbolzen durch die Lochbohrungen hindurch eine Befestigung an einer Wand erfolgen kann, in welche die Schraubenbolzen hineingeschraubt werden. Der Aufbau des Halteelementes 10, und damit der Haltevorrichtung für das elektronische Gerät 50, basiert somit beispielsweise auf einem Blechwinkel, welcher sowohl für die Wandmontage, als auch als Einschub in einen Baugruppenträger geeignet ist. Ein derartiges Einschubgerät für einen Baugruppenträger ist somit auch verwendbar zur Montage an einer Wand, beispielsweise in einem Schrank. Das erste Flächenstück 20 des Halteelementes 10 ist bei dem Einschubgehäuse als Einschubplatte vorgesehen und wird gleichzeitig damit als Kühlblech für Leistungshalbleiter verwendet. Das Kombigerät für den Schrankeinbau und für den Einschub in Baugruppenträger beansprucht wenig Platz sowohl im Baugruppenträger als auch im Schrank. Seine kompakte Form erlaubt es, daß mehrere Geräte platzsparend nebeneinander untergebracht werden können.

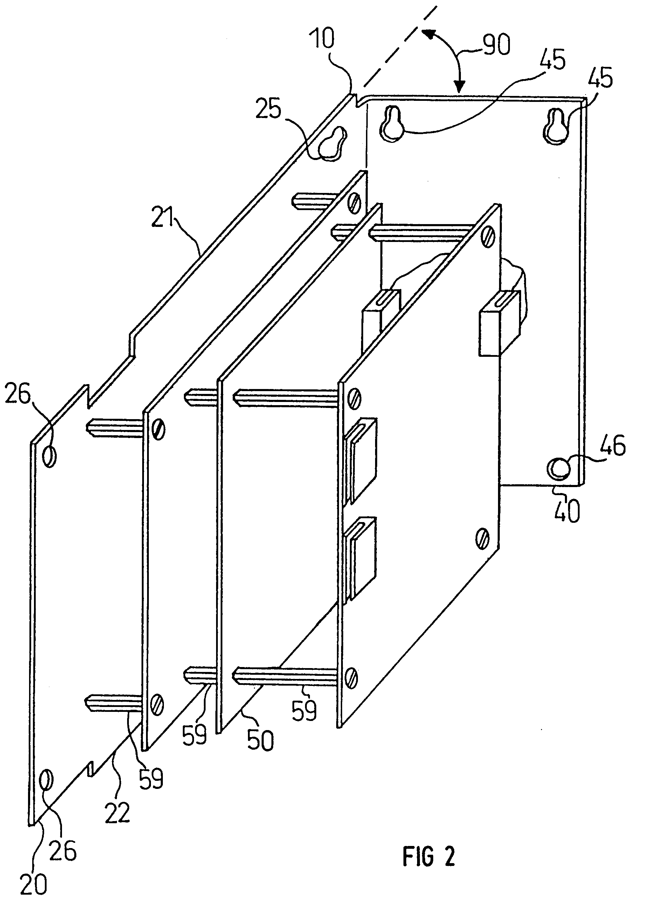

Wie die Fig. 2 zeigt, ist bei einem anderen Ausführungsbeispiel ein elektronisches Gerät 50 vorgesehen, dessen Platinen mit Hilfe von Befestigungsstegen 59 untereinander sowie an einem Halteelement 10 fixiert sind. Das Halteelement 10 weist ein erstes Flächenstück 20 und ein zweites Flächenstück 40 auf. Beim ersten Flächenstück 20 des Halteelementes 10 sind beispielsweise einander gegenüberliegend Gleitelemente 21 und 22 vorgesehen, welche zum Einschub in einen Baugruppenträger verwendbar sind. Zwischen dem ersten Flächenstück 20 und dem zweiten Flächenstück 40 des Halteelementes 10 ist ein zumindest näherungsweise rechter Winkel 90 vorgesehen. Das zweite Flächenstück 40 weist Befestigungselemente 45, 46 auf zur Wandmontage des Halteelementes 10. Das erste Flächenstück 20 weist Befestigungselemente 25, 26 auf zur Wandmontage des Halteelementes 10. Das Halteelement 10 kann somit sowohl mit Hilfe der Befestigungselemente 45, 46 als auch mit Hilfe der Befestigungselemente 25, 26 an einer Wand montiert werden.

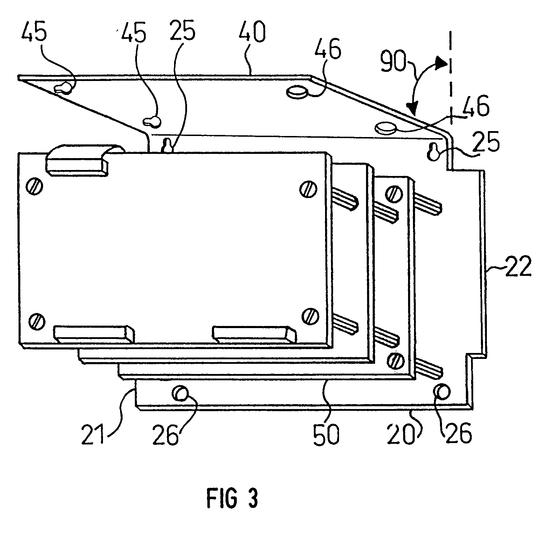

Wie die Fig. 3 zeigt, kann bei einem Ausführungsbeispiel das Halteelement 10 in einer solchen Lage an einer Wand montiert sein, daß ein Flächenstück 20 an der Wand befestigt ist, während das andere Flächenstück 40 des Halteelementes 10 aufgrund des rechten Winkels 90 zwischen den Flächenstücken 20, 40 sich oberhalb des elektronischen Gerätes 50 befindet, welches am Halteelement 10 befestigt ist. Dies kann beispielsweise zum Schutz vor herabfallenden Gegenständen vorgesehen sein. In der dargestellten Lage kann das Halteelement 10 anhand von Gleitelementen 21, 22 somit auch senkrecht in einen Baugruppenträger eingeschoben werden. In der dargestellten Lage kann das Halteelement 10 beispielsweise auch an einer Deckenfläche beispielsweise in einem Schrank befestigt werden. Hierfür sind Befestigungselemente 45, 46 des in der dargestellten Lage waagrechten Flächenstückes 40 verfügbar. Am Flächenstück 40 können zur Verbesserung der Luftzirkulation Lüftungsschlitze angeordnet werden.

Somit ist bei einer Haltevorrichtung für ein elektronisches Gerät 50 ein Halteelement 10 vorgesehen, welches geeignet ist anhand von Gleitelementen 21, 22 zum Einschub in einen Baugruppenträger, ebenso wie auch anhand von Befestigungselementen 25, 26, 45, 46 zur Wandmontage. Dadurch ist eine Vereinfachung in Form eines Kombinationsgerätes erzielbar.

## Patentansprüche

1. Haltevorrichtung für ein elektronisches Gerät (50) mit einem Halteelement (10), welches **dadurch gekennzeichnet** ist, daß in Kombination
a) ein erstes Flächenstück (20) des Halteelementes (10) vorgesehen ist, welches Gleitelemente (21,22) aufweist zum Einschub in einen Baugruppenträger,
b) ein zweites Flächenstück (40) des Halteelementes (10) vorgesehen ist, welches Befestigungselemente (45,46) aufweist zur Wandmontage des Halteelementes (10),
c) ein zumindest näherungsweise rechter Winkel (90) zwischen dem ersten und dem zweiten Flächenstück (20,40) vorgesehen ist.

2. Haltevorrichtung nach Anspruch 1, bei welcher das erste Flächenstück (20) Befestigungselemente (25,26) aufweist zur Wandmontage.

3. Haltevorrichtung nach Anspruch 1 oder 2, bei welcher das Halteelement (10) ein Druckgußteil ist mit integrierten Kühlkörpern (60).
